# EUROPEAN PATENT SPECIFICATION

(11) **EP 0 304 220 B1**
(45) Date of publication and mention of the grant of the patent: **07.12.1994**
(21) Application number: 88307417.1
(22) Date of filing: 10.08.1988
(51) Int. Cl.: C23C 16/26

(54) **Thin film carbon material and method of depositing the same**
Dünnfilmkohlewerkstoff und Verfahren zum Aufbringen
Matériau constitué d'un film fin de carbone et procédé pour son dépôt

(30) Priority: 10.08.1987 JP 200351/87; 17.07.1988 JP 177847/88; 17.07.1988 JP 177848/88; 17.07.1988 JP 177849/88
(43) Date of publication of application: 22.02.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP); Hayashi, Shigenori, Atsugi-shi Kanagawa-Ken (JP)
(74) Representative: Milhench, Howard Leslie

(56) References cited:
- EP-A- 0 063 493
- EP-A- 0 175 980
- EP-A- 0 278 480
- PATENT ABSTRACTS OF JAPAN, vol. 10, no. 182 (C-356)[2238], 25 June 1986; & JP-A-61 30 671
- IBM TECHNICAL DISCLOSURE BULLETIN, vol. 23, no. 6, November 1980, New York, NY, US; J.W. COBURN et al.: "Metal-containing polymer films formed by simultaneous etching and polymerization"
- PATENT ABSTRACTS OF JAPAN, vol. 8, no. 118(C-226)[1555], 31st May 1984; & JP-A-59 30 709

## Description

### BACKGROUND OF THE INVENTION

This invention relates to a photosensitive member and a method of forming the same upon the surface of an object.

Recently, ECR (Electron Cyclotron Resonance) CVD has attracted the interest of researches as a new method of manufacturing thin films, particularly amorphous thin films. For example, Matsuo et al discloses one such ECR CVD apparatus in US Patent No. 4,401,054. This recent technique utilizes microwave energy to energize a reactive gas so that it develops into a plasma. A magnetic field functions to pinch the plasma gas within an excitation space within which the reactive gas can absorb the microwave energy. A substrate which is required to be coated is located at a deposition space distant from the excitation space (resonating space) for preventing the substrate from being sputtered and the energized gas is showered onto the substrate from the resonating space for coating the substrate. In order to establish electron cyclotron resonance the pressure in the resonating space is kept at about 1.33x10⁻³Pa (1x10⁻⁵Torr), and at this pressure electrons can be considered as independent particles and will resonate with the microwave energy in an electron cyclotron resonance wherever the magnetic field strength meets the requirements for ECR. The excited plasma is extracted from the resonating space by means of a divergent magnetic field and is conducted to the deposition space for coating of the substrate.

It is very difficult by use of such a prior art method to deposit polycrystalline or single-crystalline carbon structures, and currently available methods are substantially limited to processes for manufacturing amorphous films. Furthermore, high energy chemical vapour reactions cannot readily be accomplished by such prior art methods and therefore it has not been possible hitherto to form diamond films or other films having high melting points, and it has not been possible to form uniform films on a surface having depressions and cavities. Furthermore, it has not previously been possible to coat the surface of a super hard metal, such as tungsten carbide, with a carbon film and because of this it has been necessary in order to manufacture abrasives of sufficient hardness to coat a super-hard surface with fine diamond powder and to make strong mechanical contact between the diamond powder and the super-hard surface.

Furthermore, it is useful to be able to deposit a hard film on a surface of glass, plastics, metal, resin and so forth for the purpose of protecting the surface from mechanical attack by abrasion or scratching. Films made of A1₂0₃, TiN, BN, WC, SiC, Si₃N₄ and Si0₂ and those described in JP-A-4344588 have been proposed for this purpose. However, such conventional protective films have high electrical resistivities and, as a result, tend to accumulate static electricity which causes them to collect dust and other fine particles on their surfaces from the surrounding atmosphere. In applications of such conventional films which make use of their static electricity properties, aging of the films is found to be accelerated because of the electric charge accumulated on the films and, whilst it is known that such shortcomings can be avoided if a conductive substance is added into the protective film, in such a case however the added substance can constitute an absorption centre for incident light thereby impairing the translucency of the film so that it cannot be used for applications in which a high degree of transmissivity is required.

Still further, it is likely that such conventional films may be subject to peeling because of accumulated internal stresses depending on the deposition conditions. Accordingly, the thickness of the film may have to be reduced or an intermediate film having high adhesivity may have to be interposed between the protective film and the underlying surface.

### OBJECTS AND SUMMARY OF THE INVENTION

EP-A-0175980 discloses a hard carbonaceous film formed on a substrate by deposition from a gas which optionally includes a halogen compound.

EP-0278480 (forming part of the state of the art only by virtue of article 54(3)) discloses the deposition of a hard carbon film on a photosensitive printing drum.

According to the present invention there is provided a photosensitive member comprising a structure including a photosensitive layer characterised in that it includes a passivation film formed on said photosensitive layer, the passivation film including first and second carbonaceous layers containing halogen atoms, the first carbonaceous layer being adjacent said photosensitive layer and the second carbonaceous layer being formed on said first carbonaceous layer, and the concentration of halogen atoms in the first layer being lower than that in the second layer and the thickness of the first layer being substantially less than that of the second layer.

Also provided according to the present invention is a method of manufacturing such a member, characterised by the steps of forming a passivation film over the photosensitive layer by CVD whereby in addition to a carbon compound gas a halogen containing gas is introduced in to a reaction chamber, the passivation film including first and second carbonaceous layers containing halogen atoms, the first layer being formed by deposition onto said photosensitive layer and the second carbonaceous layer being formed by deposition onto the first carbonaceous layer, the flow rate of halogen containing gas for producing the first layer being lower than that for producing the second layer, and the deposition time for the first layer being substantially less than that for the second layer.

Further provided according to the present inention is the use of such a member in electrophotography for forming an image in accordance with the existence or absence or incident light rays on the member.

Further provided according to the invention is an image forming apparatus comprising means for charging such a photosensitive member; for causing some regions of the member to receive light rays and not others; for applying toner to the member; and for transferring the toner to the surface of a sheet to construct an image thereon.

Examples of halogen compound gases which can be used in the practice of the present invention are fluorine compounds such as NF₃, SF₃ and WF₆, chlorine compounds such as CC1₄, bromine compounds such as CH₃Br and iodine compounds. The carbon material formed in accordance with the present invention may contain halogen atoms at 0.1-50 atom%, and this proportion may be controlled by adjusting the rate of introduction of the halogen or halogen compound gas into the reaction chamber.

Among the halogens, fluorine is preferred from the view point of avoiding corrosion of the inner wall of the reaction chamber. The carbon compound gas preferably does not include any halogen element, so that the proportion of halogen additive in the carbon film can be easily controlled. In the case of the reaction between CH₄ and CF₄, radical carbon atoms are generated in accordance with the equation:

CH₄ + CF₄ ------> 2C + 4HF

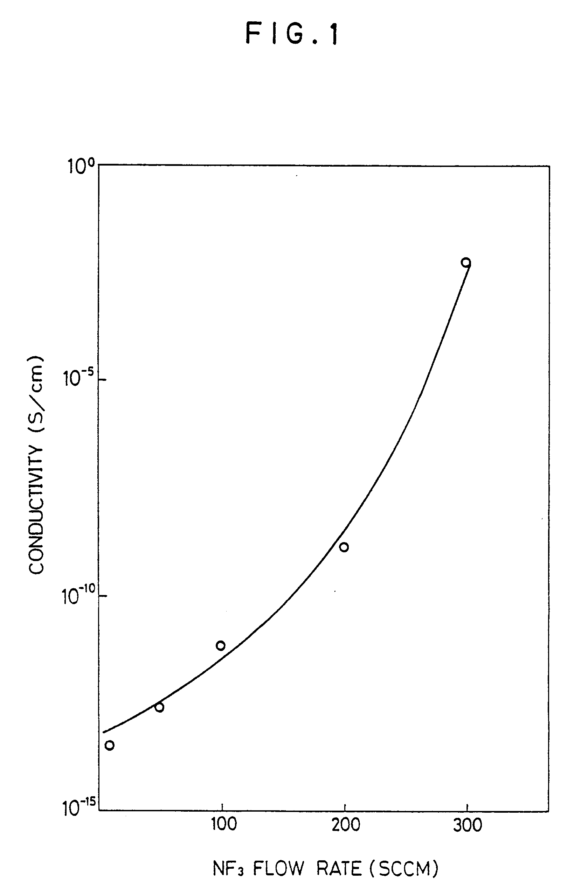

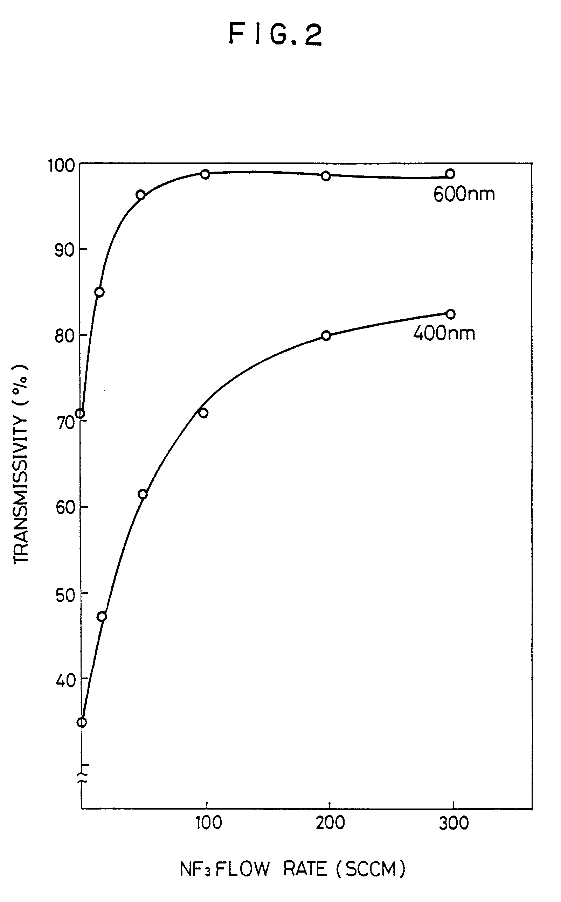

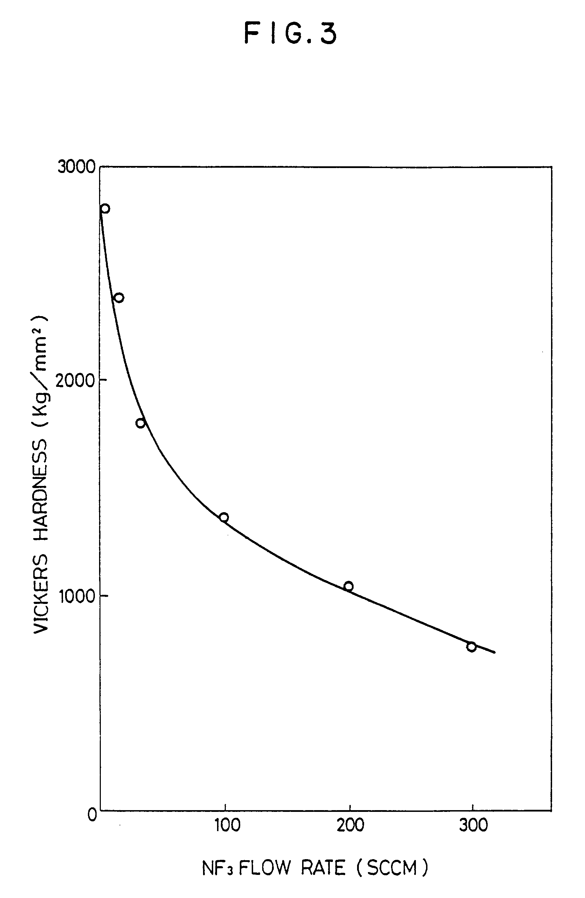

The conductivity, transparency and hardness of carbon materials produced in accordance with the present invention varies in accordance with the proportion of halogen, and in the following various experimental results will be described. In accordance with one series of experiments, carbon coatings were deposited using ethylene introduced at 10 SCCM and NF₃ introduced at varied rates. The pressure in the reaction chamber was 10 Pa and input power was 800 Wm⁻² (0.08 W/cm²). The relationship between the conductivity of the resulting carbon films and the rate of introduction NF₃ is shown in Fig.1 of the accompanying drawings and it will be seen that the conductivity increased as the rate of introduction of NF₃ was increased. The relationship between the transparency of the carbon films and the introduction rate of NF₃ is plotted in Fig.2 of the accompanying drawings and it will be seen that the transparency increased as the rate of introduction of NF₃ was increased. The relationship between the hardness of the carbon films and the introduction rate of NF₃ is plotted in Fig.3 of the accompanying drawings and it will be seen that the hardness decreased as the rate of introduction of NF₃ was increased. A decrease in hardness corresponds to a decrease in the stresses within the carbon film.

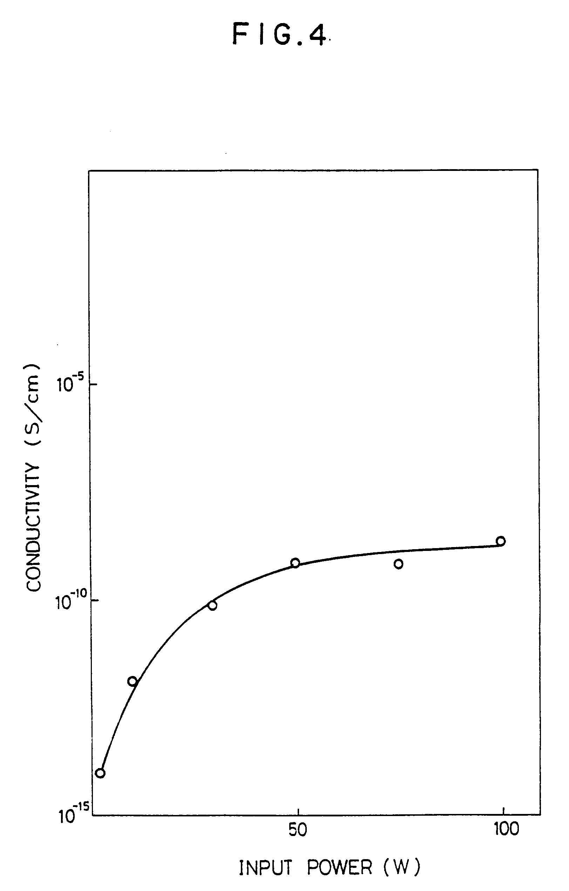

As described above, the conductivity, hardness and transparency of films deposited in accordance with the present invention can be easily controlled over wide ranges. In the following description and claim "transparency" and "transmissivity" are intended to have the same meaning. An optimal property required for a particular application can be attained at a relatively low production cost. The proportion of halogen can be controlled by changing the rate of introduction of the halogen or halogen compound gas while other deposition conditions are kept constant. Additionally, the proportion of halogen can be changed by changing any one or more of the input power, the reaction pressure, the shape of the discharge vessel and the rate of introduction of the productive carbon gas. For instance, the variation of the conductivity of the carbon film which is obtained when the input power is changed is plotted in Fig.4 of the accompanying drawings. As shown in the diagram, the conductivity increases as the input power increases. It will be understood that the other deposition conditions, such as the NF₃ flow rate and C₂H₄ flow rate, were maintained constant for obtaining the results plotted in Fig.4.

Another advantage of carbon films obtained in accordance with the present invention is that low internal stress occurs in the deposited films. Dangling bonds have a tendency to increase internal stress and, whilst dangling bonds can be terminated by hydrogen atoms introduced into carbon films, even with the introduction of hydrogen atoms some unterminated dangling bonds inevitably still remain and might be a cause of internal stress. If, by virtue of the present invention a halogen such as fluorine exists in the plasma gas, C-F bonds will be easily created and, as a result, the density of dangling bonds will be substantially reduced by their termination by fluorine atoms.

A further advantage of the present invention is that it produces carbon films having a high heat-resistant property.

Yet a further advantage of the present invention is that the process of the invention can be performed at such low process temperatures that carbon coatings can be formed even on selenium or on organic materials such as plastics.

According to another aspect of the invention, a new CVD process is proposed which utilizes mixed cyclotron resonance (MCR). In the improved exciting process, sonic action of the reactive gas itself must be taken into consideration as a non-negligible perturbation besides the interaction between respective particles of the reactive gas and the magnetic and microwave fields, and as a result charged particles of reactive gas can be energized throughout a relatively wide resonating space. Preferably, the pressure is maintained higher than 400Pa (3 Torr). For mixed resonance, the pressure in the reaction chamber is elevated 10²⁻10⁵ times as high as that of the prior art. For example, mixed resonance can be established by increasing the pressure after ECR takes place at a low pressure. Namely, first a plasma gas is placed in ECR condition at 0.133Pa to 1.33mPa (1x10⁻³ to 1x10⁻⁵Torr) by inputting microwave energy under the existence of a magnetic field, and then a reactive gas is inputted into the plasma gas so that the pressure is elevated to 13.3Pa to 40kPa (0.1 to 300 Torr) and the resonance is changed from ECR to MCR.

Other features of the invention are set forth with particularly in the appended claims and, together with the above mentioned aspects of the invention, will become well understood by those possessed of the relevant skills from consideration of the following detailed description given with reference to the accompanying drawings.

### BRIEF DESCRIPTION OF THE DRAWINGS

Fig.1 is a graphical diagram showing the relationship between the conductivity of a carbon film forming part of the present invention and the NF₃ flow rate;
Fig.2 is a graphical diagram showing the relationship between the transmissivity of a carbon film forming part of the present invention and the NF₃ flow rate;
Fig.3 is a graphical diagram showing the relationship between the Vickers hardness of a carbon film forming part of the present invention and the NF₃ flow rate;
Fig.4 is a graphical diagram showing the relationship between the conductivity of a carbon film forming part of the present invention and the input power level;
Fig.5 is a cross-sectional view showing an exemplary CVD apparatus for fabricating a film forming part of the present invention;
Fig.6 is a graphical diagram showing the relationship between transmissivity and wavelength for a carbon film forming part of the present invention;
Fig.7 is a cross-sectional view showing another CVD apparatus for fabricating a film forming part of the present invention;
Fig.8(A) is a graphical diagram showing a computer simulation of the cross-sectional profiles of the magnetic field equipotential surfaces in the substrate coating region of the apparatus of Fig.7;
Fig.8(B) is a graphical diagram showing the electric field strength of the microwave energy in the plasma generating space of the apparatus of Fig.7;
Figs. 9(A) and 9(B) are graphical diagrams showing equipotential surfaces of the magnetic field and electric field respectively of the microwave energy propagating in the resonating space;
Fig.10 is a cross-sectional view showing a further CVD apparatus for fabricating a film forming part of the present invention;
Fig.11 is a cross sectional-view showing yet another CVD apparatus for fabricating a film forming part of the present invention; and
Fig.12 is a cross-sectional view showing a device in accordance with the present invention.

### DETAILED DESCRIPTION OF THE PREFERRED EMBODIMENTS

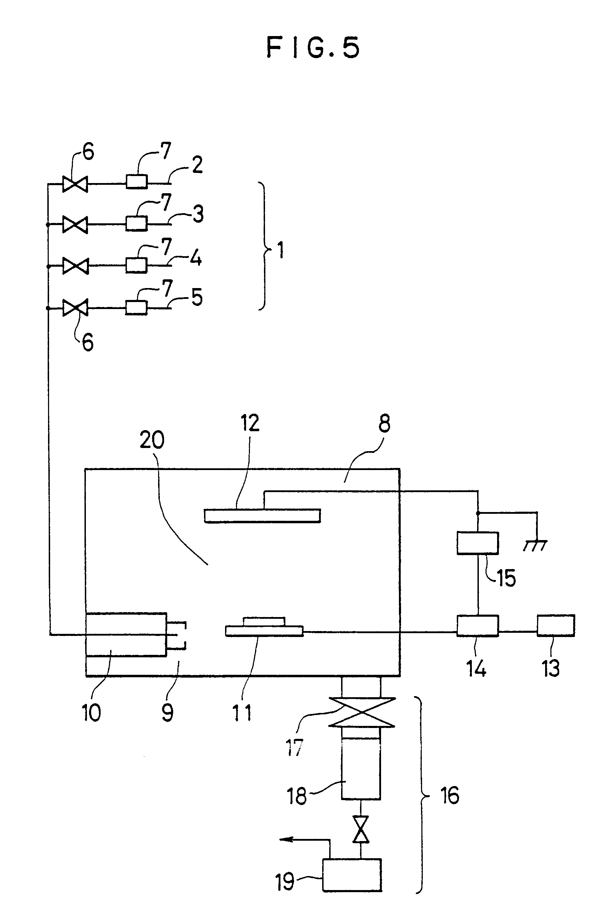

Referring to Fig.5, there is shown therein a plasma CVD apparatus adapted for depositing carbon material on a surface of a photosensitive member in accordance with the teachings of the present invention. The surface to be coated may for example be made of glass, metal, ceramics, organic resins and so forth.

The apparatus comprises a reaction chamber 8 defining a reaction space 20 therein, first and second electrodes 11 and 12, a high frequency electric power source 13 for supplying electric power through a matching transformer 14, a DC bias source 15 connected in series between the electrodes 11 and 12, a gas feeding system 1 consisting of four passages each of which is provided with a flow meter 7 and a valve 6, a microwave energy supply 10 for exciting gases from the feeding system 1, a nozzle 9 through which gas excited by the microwave energy supply 10 is introduced into the reaction space 20, and an exhaust system 16 including a pressure control valve 17, a turbo-molecular pump 18 and a rotary pump 19. The electrodes are designed such that ( $\text{the area of the first electrode 11)/(the area of the second electrode 12) < 1}$ 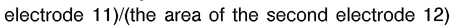 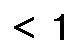 .

In operation of this apparatus, a carrier gas of hydrogen is introduced to the reaction space 20 from the gas feeding passage 2 as well as a reactive gas of a hydrocarbon such as methane or ethylene from the gas feeding passage 3. In addition to this, a halogen compound gas such as NF₃ is inputted to the reaction space 20 through the gas feeding passage 4. Preexcitation may be effected by the microwave energy supply 10. The pressure in the reaction space is maintained within the range between 0.133Pa to 1.33kPa (0.001 to 10 Torr), preferably 1.33Pa to 133Pa (0.01 to 1 Torr). High frequency electric energy at a frequency not lower than 1 GHz, preferably 2.45 GHz, is applied to the reactive gas at 0.1 to 5 kilo watt for breaking C-H bonds. When the frequency is selected to be 0.1 to 50 MHz, C=C bonds can be broken and transformed to -C-C- bonds. By virtue of this reaction, carbon atoms are deposited with a few halogen atoms in the form of a structure in which the diamond structure occurs at least locally.

A bias voltage of -200 to 6000 V is set at the DC bias source 15. The effective bias voltage level is substantially -400 to +400 V since a self bias level of -200 V is spontaneously applied between the electrodes 11 and 12 with the bias voltage level at the source 15 being zero.

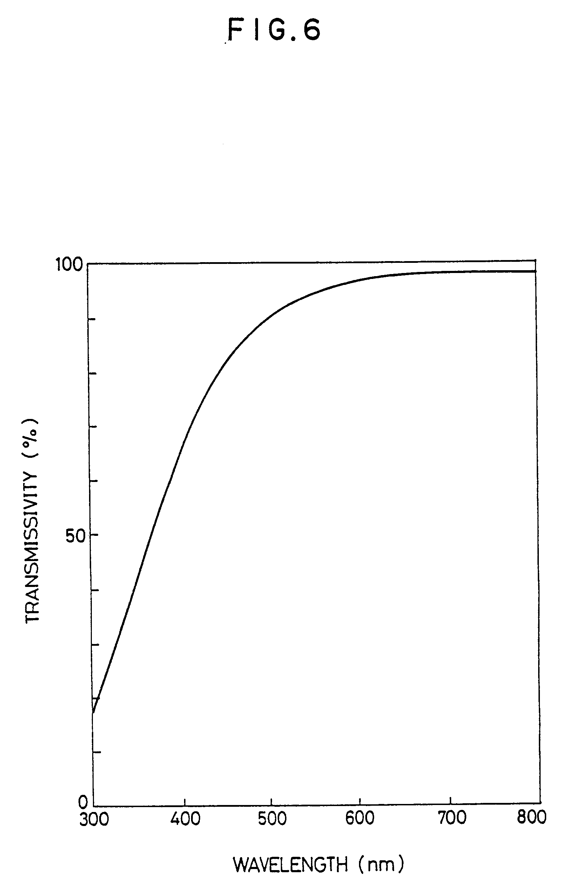

An experiment was carried out under deposition conditions in which the high frequency input power was chosen between 50 watt and 1 kilo watt, e.g. 60 watt, the pressure in the reaction space was 2Pa (0.015 Torr), the flow rate of ethylene was 100 SCCM , the flow rate of NF₃ was 100 SCCM , the substrate temperature was room temperature, and the deposition time was 30 minutes. This level of input power corresponds to 0.3-30kWm⁻² (0.03 to 3 watt/cm²) in terms of plasma energy. The transmissivity of the deposited carbon film containing fluoride atoms was measured for different wavelengths of light and is plotted in Fig.6. As is shown in Fig.6, the transmissivity was not lower than 95% at wavelengths longer than 600 nm and not lower than 50% at a wavelength of 400 nm. The Vickers hardness was measured to be 1x10⁷-2.5x10⁷kgm⁻² (1000 to 2500 kg/cm²). The internal stress was measured to be as small as no higher than 100Nm⁻² (10⁷dyn/m²). No appreciable deterioration of the surface of the deposited film was noted when the film was examined by means of an optical microscope at 400 times magnification after the surface had been immersed for an hour in caustic chemicals such as acids, alkalis, organic solvents and the like. Also, no appreciable change was observed after leaving the film in an incubator at 500°C for an hour.

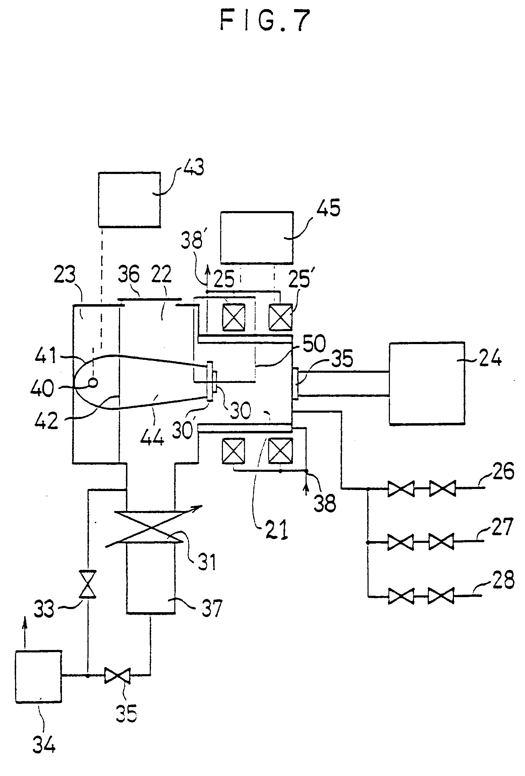

Referring to Fig.7, an exemplary microwave enhanced plasma CVD apparatus in accordance with the present invention is illustrated as a second embodiment. As shown in the figure, the apparatus comprises a reaction chamber in which a plasma generating space 21 and an auxiliary space 22 are defined which can be maintained at an appropriate negative pressure, a microwave generator 24, electromagnets 25 and 25' in the form of Helmholtz coils surrounding the space 21, a power supply 45 for supplying electric power to the electromagnets 25 and 25', and a water cooling system 38, 38'.

The plasma generating space 21 has a circular cross-section, and within the plasma generating space there is provided a substrate holder 30' made of a material such as stainless steel or quartz for example which provokes minimum disturbance of the magnetic field created by the magnets 25 and 25' in the chamber. A substrate 30 is shown mounted on the holder 30'. The substrate holder 30' is irradiated and heated to 800-1000°C in a high temperature plasma gas region by means of infrared radiation 44 which is emitted from an IR heater 40, reflected from an IR reflection parabolic mirror 41 and focused on the back surface of the holder 30' through a lens 42. Reference numeral 43 designates a power supply for the IR heater 40. Provided for evacuating the reaction chamber is an evacuating system comprising a turbo-molecular pump 37 and a rotary pump 34 which are connected with the reaction chamber through pressure controlling valves 31, 33 and 35. The substrate temperature may reach a sufficient level solely by virtue of the plasma gas generated in the reaction chamber and, in this case, the heater can be dispensed with. Further, depending on the condition of the plasma, the substrate temperature might become too high to enable a suitable reaction to occur, in which case cooling means for the substrate has to be provided.

In use of the above described apparatus, a substrate 30 of silicon wafer is mounted on a substrate holder 30', and the reaction chamber is evacuated to 0.133mPa (1 x 10⁻⁶) Torr or a higher vacuum condition. Then, hydrogen gas is introduced from a gas introducing system 26 at 100 SCCM to fill the plasma generating space 21, and microwave energy at a power level of 1 kilo watts and a frequency of 2.45 GHz is injected from the microwave generator 24 through a microwave introduction window 35 into the plasma generating space 21 which is subjected at the same time to a magnetic field of about 0.2T (2 k Gauss) generated by the magnets 25 and 25'. The magnets are adapted to adjust the magnetic field strength. The hydrogen is excited into a high density plasma state in the space 21. The surface of the substrate 30 is cleaned by high energy electrons and hydrogen atoms. In addition to the introduction of hydrogen gas, a productive gas comprising a hydrocarbon such as C₂H₂, C₂H₄, C₂H₆, CH₃0H, C₂H₅0H or CH₄ for example and a halogen compound gas such as CF₄, C₂F₂, C₂F₄, C₂C1₂ or C₂C1₄ for example are inputted at 30 SCCM (total rate) through a gas introduction system 27. The proportion of halogen compound gas is 50%. The introduction rate of carrier gas (hydrogen) is selected between 30 SCCM and zero, for example 2 SCCM .

Since chlorine is somewhat corrosive, fluorine is the most suitable halogen in view of its ease of handling and high reactiveness to hydrogen. The reactive gas and the carrier gas are preferably non-oxide gases since, if water is formed, strong acids such as HF and HC1 might be formed.

Carbon atoms excited to high energy states are generated at 150-500°C, and are deposited on the substrate 30 on the substrate holder 30' in the form of a film of 0.1 to 100 µm thickness containing fluoride. The pressure of the reactive gas is from 400Pa-107kPa (3-800 Torr) and preferably not lower than 1.33kPa (10 Torr), such as 1.33kPa-101kPa (10-760 Torr). The carbon film that was produced had a smooth surface and was abrasion-proof and corrosion-proof, and therefore suitable for application to instruments for use in chemical experiments.

In addition to the above described reactive gas, Ni(CO)₄ at 1 SCCM (and GeH₄ at 2 SCCM in addition, if necessary) as a catalyst may be inputted to the reaction chamber from the introduction system, the proportion of the catalyst to the carbon compound gas being 0.1% to 10%. NiF, Ni0, NiF(H₂0)ₙ (where n = 1.3), Ni(CN)₂, Ni(C₅H₅)₂, GeH₄, GeF₄, manganese carbonyl, MnF₂ and the like are examples of other catalysts. They can be used alone or in various combinations. The CVD reaction which occurs results from carbon atoms being excited to a high energy condition and being heated to 150-500°C by virtue of the plasma gas and the heater 40 so that the substrate 30 mounted on the substrate holder 30' is coated with carbon in the form of a 0.1-100 µm thick film of i-carbon (insulated carbon consisting of microcrystals) or diamond having a grain diameter of from 0.1 to 100 µm. In accordance with experimental results, it took only two hours to deposit a carbon film having an average thickness of 5 µm. The deposition speed can be increased by applying a bias voltage to the substrate holder. The carbon product in accordance with the present embodiment is characterized in that at least 50% of carbon atoms have been connected by sp³ bonds.

For reference, a film formation process was performed in the same manner as in the above but without using a catalyst. As a result, it took 15 hours to form a carbon film having an average thickness of 4 µm. It was confirmed by an optical microscope (1000 times magnification) that the unevenness of the surface of the film was significant. In accordance with the present invention, since innumerable seeds of catalyst prevail over the surface to be coated, carbon films can be formed with flat surfaces.

In the case where the reactive gas was CH₄:CF₄ = 2:1, thin films containing diamond structures therein could be formed at 13,33 kPa (100 Torr) at a temperature not lower than 400°C. In the case of CH₄:CF₄ = 1:1, the formation temperature was 300°C and the reaction pressure was 6.67kPa (50 Torr). In the case of CH₄:CF₄ = 1:2, thin films containing diamond structures could be formed at 200°C and 1.33kPa (10 Torr). While the pressure is preferably around atmospheric pressure, low temperatures are desirable because the choice of substrates to be coated then becomes broad.

At temperatures not higher than 400°C, carbon deposition can be performed on a semiconductor substrate over an aluminium circuit formed thereon. At temperatures not higher than 200°C, carbon coating on a plastics substrate becomes possible. At temperatures between 300°C and 500°C, carbon coatings can be deposited on glass substrates.

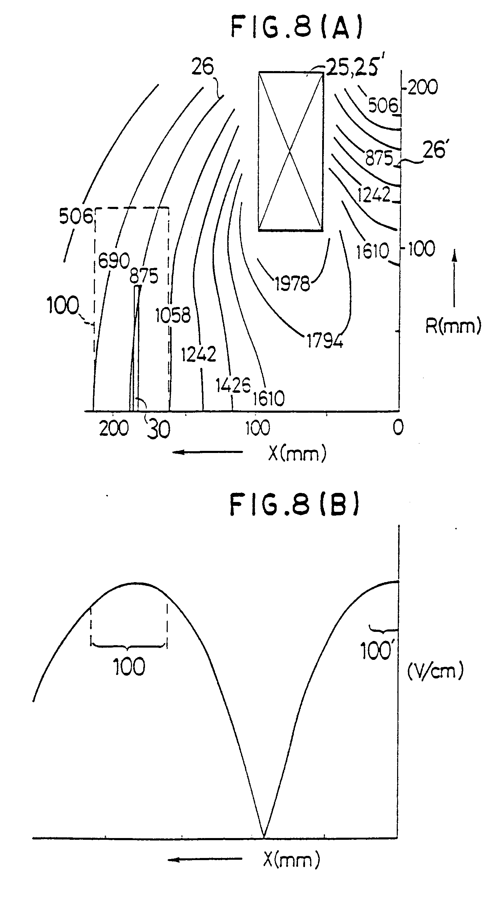

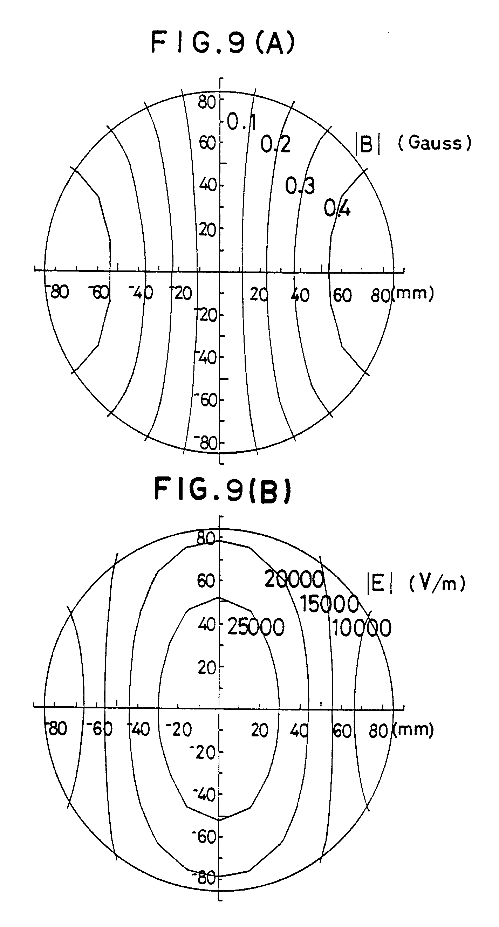

Fig.8(A) is a graphical showing of the distribution of the magnetic field in the region 50 of the apparatus shown in Fig.7. The curves in the diagram are plotted along equipotential surfaces and are given numerals indicating the strengths along the respective curves of the magnetic field induced by the magnets 25 and 25' which have a power of 0.2T (2000 Gauss). By adjusting the power of the magnets 25 and 25', the strength of the magnetic field can be controlled so that the magnetic field becomes largely uniform over the surface to be coated which is located in the region 100 where the magnetic field 87.5mT ± 18.5mT (875 ± 185 Gauss) and the electric field interact. In the diagram, the reference 26, 26' designates the equipotential surface of 87.5mT (875 Gauss) at which the conditions required for ECR (electron cyclotron resonance) between the magnetic field and the microwave frequency are satisfied. Of course, in accordance with the present invention, ECR cannot be established due to the high pressure in the reaction chamber, but instead a mixed cyclotron resonance takes place in a broad region including the equipotential surface which satisfied ECR conditions. Fig.8(B) is a graphical diagram in which the X-axis corresponds to that of Fig.8(A) and shows the strength of the electric field of the microwave energy in the plasma generating space 21. As shown, the electric field strength attains its maximum value in the regions 100 and 100', it is difficult to heat the substrate 30 without disturbing the propagation of the microwave energy. In other regions, a film will not be uniformly deposited, but will be deposited in the form of a doughnut. It is for this reason that the substrate 30 is disposed in the region 100. The plasma flows in the lateral direction. According to experiments, a uniform film can be formed on a circular substrate having a diameter of up to 100 mm, and a film can be formed in the chamber on a circular substrate having a diameter of up to 50 mm with uniform thickness and uniform quality. When a larger substrate is desired to be coated, the diameter of the space may be doubled with respect to the vertical direction of Fig.8(A) by making use of 1.225 GHz as the frequency of the microwave energy. Fig.9(A) and Fig.9(B) are graphical diagrams showing the distribution of the magnetic field and the electric field due to microwave energy emitted from the microwave generator 24 for a cross-section of the plasma generating space 21. The curves in the circles of the figures are plotted along equipotential surfaces and given numerals showing the field strengths. As shown in Fig.9(B), the electric field reaches its maximum value at 25 kV/m.

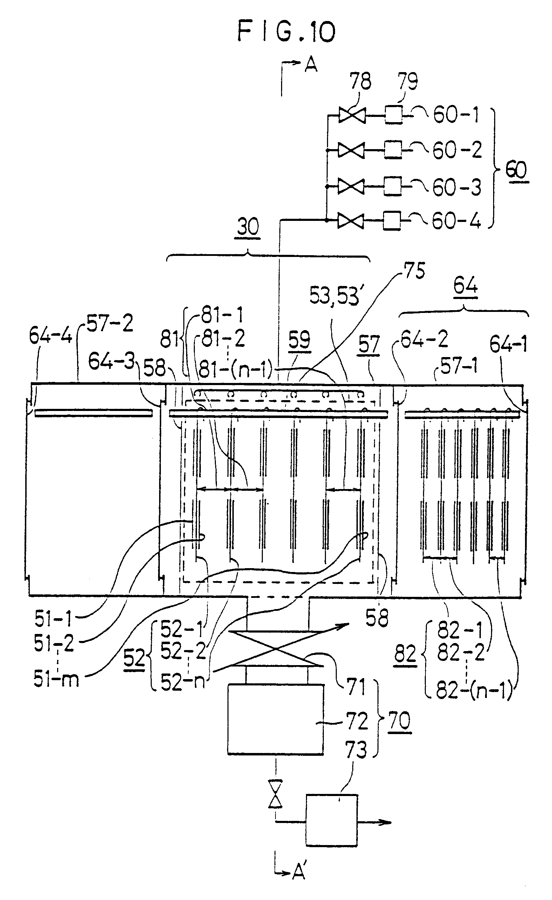

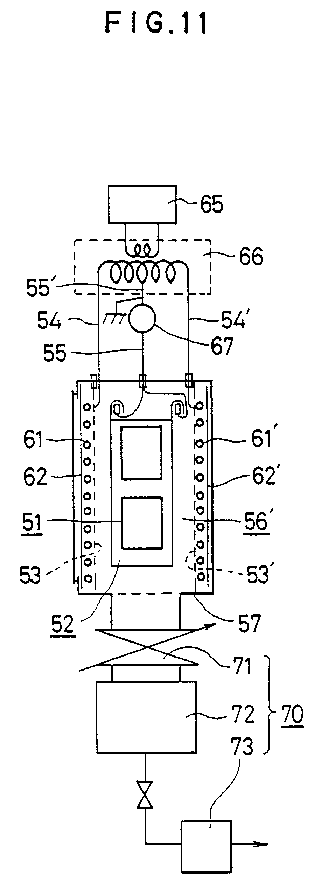

Next, a third embodiment will be described referring to Figs.10 and 11. A large size plasma treatment system comprises a reaction chamber 57 provided with a loading chamber 57-1, an unloading chamber 57-2, a pair of guide rails 59 for suspending therefrom a plurality of substrate holders 52 made of aluminium or nickel plates, a high frequency electric power source 65 for supplying electric power through a matching transformer 66, first and second metallic mesh electrodes 53 and 53' connected to the output terminals 54 and 54' of the transformer 66, the geometric area of each electrode being 1.5x10⁻²m² (150 cm²) and the effective area of each electrode being 1.2x10⁻²m² (120 cm²), an alternating electric power source 67 connected between the midpoint of the secondary coil of the transformer and the guide rails 59, a gas feeding system 60 consisting of four passages each of which is provided with a flow meter 79 and a valve 78, a nozzle 75 for inputting gases to the reaction chamber 57 from the gas feeding system 60, and an exhaust system 70 including a pressure control valve 71, a turbo-molecular pump 72 and a rotary pump 73. A reaction space is defined within the reaction chamber by means of a four-sided hollow structure 58 of 1.6m (160 cm) width, 0.4m (40 cm) depth and 1.6m (160 cm) height for blocking deposition on the inside wall of the reaction chamber 57. The height of the hollow structure may be chosen between 0.2m (20cm) and 5m in general. One dimension of the electrodes 53 and 53' may be chosen between 0.3m (30 cm) and 3m in general. There are provided gate valves 64-1 and 64-4 between the outside of the loading and unloading chambers 57-1 and 57-2 and gate valves 64-2 and 64-3 between the reaction chamber 57 and the loading and unloading chambers 57-1 and 57-2 for sealing off. The inside of the reaction chamber 57 is provided with a heater consisting of a plurality of halogen lamps 61 and 61'.

A plurality of substrates 51-1, 51-2, ..51-m are mounted on the plurality of substrate holders 52-1, 52-2, ...52-n. The distances 81-1, 81-2, ..81-(n-1) between adjacent holders in the reaction chamber 57 are selected to be substantially constant, the dispersion from the average being within ±20%. The corresponding distances 82-1, 82-2, ..82-(n-1) respectively in the loading chamber 57-1 are selected to be narrower for the purpose of designing the system to be compact. In this arrangement, only one side surface of each substrate is coated. If coating of both surfaces is desired, the substrates may be supported in openings formed on the holders. Introduced to the reaction chamber 57 are a carrier gas of argon or hydrogen from the passage 60-1 of the gas feeding system, a reactive gas of a hydrocarbon such as methane or ethylene from the passage 60-2, and a halogen compound gas such as NF₃ from the passage 60-3. The pressure of the reactive gas is 0.133Pa to 133Pa, e.g. 6.65Pa (0.001 to 1.0 Torr, e.g. 0.05 Torr). The substrate temperature is 100°C (in case with a cooling system) or up to 150°C.

A first alternating voltage is applied between the mesh electrodes 53 and 53' at a high frequency of 1 MHz to 5 GHz, e.g. 13.56 MHz, while a second alternating voltage is applied between the midpoint of the secondary coil and the rails 59 at a frequency of 1 kHz to 500 kHz, e.g. 50 kHz. The input power of the first alternating voltage is 1.0 kW to 30 kW (equivalent to a plasma energy of 400KWm⁻² - 13MWm⁻² (0.04-1.3 kW/cm²)), e.g. 10 kW (equivalent to a plasma energy of 4.4MWm⁻² (0.44W/cm²)). The second alternating voltage functions to apply a AC bias voltage of -200 to 600 V (equivalent to 500W) at the substrate surface. By virtue of this electric power, a plasma gas is generated in the reaction chamber 57 and initiates chemical vapour reaction. The exhaust gas is removed through the evacuation system 70.

In the following, some experimental results will be described in detail, these results having been obtained in accordance with the aforementioned embodiments and combinations thereof.

### EXAMPLE:

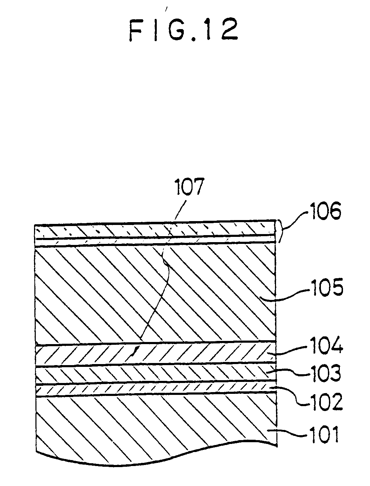

In accordance with the present invention, a photosensitive structure for use in electron photography was formed as illustrated in Fig.12. The structure comprises a PTE sheet 101 of 20 µm thickness, an aluminium film 102 of 60nm (600 Å) thickness formed by vacuum evaporation, an intermediate film 103, a charge generating film 104 of 0.6-1.2 µm thickness, a charge transfer film 105 of 20 µm thickness and a passivation film 106 formed in accordance with the present invention. The passivation film 106 in this case was composed of two layers.

If the passivation film or the charge generating film is given a negative electric charge, some portion of the structure receiving light rays 107 can be neutralized by holes generated in the charge generating film 104 which reach the passivation film 106 through the charge transfer film 105. In this case, electrons generated in the charge generating film 104 are drained through the intermediate film and the aluminium film. Any other region which does not receive light rays can be used to attract toner and to transfer it to the surface of a paper sheet to construct an image in accordance with the existence or absence of incident light rays.

The resistivity of the passivation film 106 was controlled to be 10⁹ to 10⁷ ohm m (10¹¹ to 10⁹ ohm cm) by adjusting the flow rate of NF₃. A lower layer was deposited at a NF₃ flow rate not higher than 0.1 SCCM for two minutes and then the upper layer was deposited at 100 SCCM for the following 20 minutes. The resistivity, the transparency, the hardness, the internal stress and the other characteristics were found to depend almost entirely on the properties of the upper layer. Only the adhesivity depended on the lower layer which made strong mechanical contact to the underlying substrate.

By virtue of such a high resistivity, the disadvantage that the boundary of the constructed image became out of focus due to lateral drift of charge was avoided. Accordingly, the formed image became clear with high contrast. On the other hand, if the resistivity were too high, residual charge might be accumulated after repeated charge and discharge. This adverse accumulation could be avoided by precisely controlling the resistivity in accordance with the present invention. The transmissivity of the passivation film was not lower than 80% to light rays of 500 nm or longer wavelengths, and not lower than 60% to light rays of 400 nm or longer wavelength. Accordingly, the structure can be employed for applications making use of wavelengths of visible light.

Furthermore, the passivation film was abrasion-proof and scratch-proof and was superior in adhesivity with lower internal stress. No cracking and no peeling was caused in the photosensitive film on a flexible sheet even when the sheet was bent at a radius of curvature of 10 mm. This experiment was made for application to a sheet-like organic photosensitive structure. However, similar structures can be formed in the same manner as photosensitive drums, amorphous silicon photosensitive structures and selenium photosensitive structures.

Another layer with lower proportion of fluorine may be further deposited over the upper layer in order to increase the hardness of the external surface of the passivation film.

In accordance with the present invention, improved carbon films or clusters can be formed. The effect of the invention has been confirmed in regard to carbon deposition, and therefore it is advantageous to apply the present invention to the formation of any films containing carbon whose proportion is not lower than 50%.

While several specific embodiments have been described herein, it is to be appreciated that the scope of the present invention is limited only by the appended claims and is not limited to the particular examples described. Modifications and variations of the described embodiments may occur to the skilled reader without departing from the invention. For example, it has been proved effective to add boron, nitrogen, phosphorus or the like into the carbon.

## Claims

1. A photosensitive member comprising a structure including a photosensitive layer (104, 105) characterised in that it includes a passivation film (106) formed on said photosensitive layer, the passivation film including first and second carbonaceous layers containing halogen atoms, the first carbonaceous layer being adajcent said photosensitive layer and the second carbonaceous layer being formed on said first carbonaceous layer, and the concentration of halogen atoms in the first layer being lower than that in the second layer and the thickness of the first layer being substantially less than that of the second layer.

2. A photosensitive member as claimed in claim 1 including a third layer formed on the second layer to increase the hardness of the external surface of the passivation film.

3. A photosensitive member as claimed in claim 1 or 2 in which the photosensitive layer comprises a charge generating film (104) and a charge transfer film (105) formed on the charge generating film.

4. A photosensitive member as claimed in claim 3 where the thickness of the charge generating film (104) is 0.6 to 1.2µm.

5. A photosensitive member as claimed in claim 3 or 4 where the thickness of the charge transfer film (105) is 20µm.

6. A photosensitive member as claimed in any of the preceding claims wherein the resistivity of the passivation film (106) is about 10¹¹ to 10⁹ ohm cm.

7. A photosensitive member as claimed in any of the preceding claims wherein the transparency of the passivation film (106) is not lower than 80% to light rays of 500nm wavelengths or longer.

8. A photosensitive member as claimed in any of the preceding claims wherein the transparency of the passivation film (106) is not lower than 60% to light rays of 400nm wavelength or longer.

9. A photosensitive member as claimed in any of the preceding claims wherein the photosensitive layer is an organic photosensitive layer.

10. A photosensitive member as claimed in any of claims 1 to 8 wherein the photosensitive layer is an amorphous silicon or a selenium photosensitive layer.

11. A method of forming a photosensitive member according to any preceding claim comprising a structure including a photosensitive layer, characterised by the steps of forming a passivation film over the photosensitive layer by CVD whereby in addition to a carbon compound gas a halogen containing gas is introduced in to a reaction chamber, the passivation film including first and second carbonaceous layers containing halogen atoms, the first layer being formed by deposition onto said photosensitive layer and the second carbonaceous layer being formed by deposition onto the first carbonaceous layer, the flow rate of halogen containing gas for producing the first layer being lower than that for producing the second layer, and the deposition time for the first layer being substantially less than that for the second layer.

12. Use of a photosensitive member according to any of claims 1 to 10 in electrophotography for forming an image in accordance with the existence or absence or incident light rays on the member.

13. Use according to claim 12 comprising; charging the member; causing some regions of the member to receive light rays and not others; applying toner to the member; and transferring the toner to the surface of a sheet to construct an image thereon.

14. An image forming apparatus comprising means for charging a photosensitive member as claimed in any of claims 1 to 10; for causing some regions of the member to receive light rays and not others; for applying toner to the member; and for transferring the toner to the surface of a sheet to construct an image thereon.

## Patentansprüche

1. Photoempfindliches Teil mit einer Struktur mit einer photoempfindlichen Schicht (104, 105), **dadurch gekennzeichnet, daß** es einen Passivierungsfilm (106) aufweist, der auf der photoempfindlichen Schicht ausgebildet ist und der eine erste und eine zweite kohlenstoffhaltige Schicht mit Halogenatomen beinhaltet, wobei die erste kohlenstoffhaltige Schicht in direktem Kontakt mit der photoempfindlichen Schicht steht und die zweite kohlenstoffhaltige Schicht auf der ersten kohlenstoffhaltigen Schicht ausgebildet ist, wobei die Konzentration der Halogenatome in der ersten Schicht kleiner als in der zweiten Schicht ist und die Dicke der ersten Schicht wesentlich kleiner als diejenige der zweiten Schicht ist.

2. Photoempfindliches Teil nach Anspruch 1, mit einer dritten Schicht, die auf der zweiten Schicht ausgebildet ist, um die Härte der Außenfläche des Passivierungsfilms zu erhöhen.

3. Photoempfindliches Teil nach Anspruch 1 oder Anspruch 2, bei dem die photoempfindliche Schicht einen Ladungserzeugungsfilm (104) und einen auf diesem ausgebildeten Ladungsübertragungsfilm (105) aufweist.

4. Photoempfindliches Teil nach Anspruch 3, bei dem die Dicke des Ladungserzeugungsfilms (104) 0,6 bis 1,2 µm beträgt.

5. Photoempfindliches Teil nach Anspruch 3 oder Anspruch 4, bei dem die Dicke des Ladungsübertragungsfilms (105) 20 µm beträgt.

6. Photoempfindliches Teil nach einem der vorstehenden Ansprüche, bei dem der spezifische Widerstand des Passivierungsfilms (106) ungefähr 10¹¹ bis 10⁹ Ohm·cm beträgt.

7. Photoempfindliches Teil nach einem der vorstehenden Ansprüche, bei dem die Transparenz des Passivierungsfilms (106) für Lichtstrahlung der Wellenlänge 500 nm oder länger nicht kleiner als 80 % ist.

8. Photoempfindliches Teil nach einem der vorstehenden Ansprüche, bei dem die Transparenz des Passivierungsfilms (106) für Lichtstrahlung der Wellenlänge 400 nm oder länger nicht kleiner als 60 % ist.

9. Photoempfindliches Teil nach einem der vorstehenden Ansprüche, bei dem die photoempfindliche Schicht eine organische, photoempfindliche Schicht ist.

10. Photoempfindliches Teil nach einem der Ansprüche 1 bis 8, bei dem die photoempfindliche Schicht eine Schicht aus amorphem Silicium oder eine photoempfindliche Schicht aus Selen ist.

11. Verfahren zum Herstellen eines photoempfindlichen Teils nach einem der vorstehenden Ansprüche, mit einer Struktur mit einer photoempfindlichen Schicht, gekennzeichnet durch die folgenden Schritte: Herstellen eines Passivierungsfilms auf der photoempfindlichen Schicht durch CVD, wobei zusätzlich zu einem Kohlenstoffverbindungsgas ein halogenenthaltendes Gas in eine Reaktionskammer eingeleitet wird, wobei der Passivierungsfilm eine erste und eine zweite kohlenstoffhaltige Schicht mit Halogenatomen beinhaltet, wobei die erste Schicht durch direktes Abscheiden auf der photoempfindlichen Schicht hergestellt wird und die zweite kohlenstoffhaltige Schicht durch Abscheiden auf der ersten kohlenstoffhaltigen Schicht hergestellt wird, wobei die Strömungsrate von halogenenthaltendem Gas zum Herstellen der ersten Schicht kleiner als diejenige zum Herstellen der zweiten Schicht ist, und wobei die Abscheidungszeit für die erste Schicht wesentlich kürzer als die für die zweite Schicht ist.

12. Verwendung eines photoempfindlichen Teils gemäß einem der Ansprüche 1 bis 10 in der Elektrophotographie zum Herstellen eines Bilds abhängig vom Vorliegen oder Fehlen einfallender Lichtstrahlung auf dem Teil.

13. Verwendung nach Anspruch 12, umfassend: Aufladen des Teils; Verursachen, daß einige Bereiche des Teils Lichtstrahlung empfangen und andere nicht; Auftragen von Toner auf das Teil und Übertragen des Toners auf die Fläche eines Blatts zum Erstellen eines Bilds auf diesem.

14. Bilderzeugungsgerät mit einer Einrichtung zum Laden eines photoempfindlichen Teils nach einem der Ansprüche 1 bis 10, um dafür zu sorgen, daß einige Bereiche des Teils Lichtstrahlung empfangen und andere nicht, um Toner auf das Teil aufzutragen und um den Toner auf die Oberfläche eines Blatts zu übertragen, um auf diesem ein Bild zu erstellen.

## Revendications

1. Elément photosensible comprenant une structure comportant une couche photosensible (104, 105), caractérisé en ce qu'il comprend un film de passivation (106) formé sur ladite couche photosensible, le film de passivation comprenant une première et une deuxième couches carbonées contenant des atomes d'halogène, la première couche carbonée étant en contact direct avec ladite couche photosensible et la deuxième couche carbonée étant formée sur ladite première couche carbonée, et la concentration d'atomes d'halogène dans la première couche étant inférieure à celle d'atomes d'halogène dans la deuxième couche et l'épaisseur de la première couche étant sensiblement moindre que celle de la deuxième couche.

2. Elément photosensible selon la revendication 1, comprenant une troisième couche formée sur la deuxième couche pour augmenter la dureté de la surface externe du film de passivation.

3. Elément photosensible selon la revendication 1 ou 2, dans lequel la couche photosensible comprend un film générateur de charges (104) et un film de transfert de charges (105) formé sur le film générateur de charges.

4. Elément photosensible selon la revendication 3, dans lequel l'épaisseur du film générateur de charges (104) est de 0,6 à 1,2 micromètre.

5. Elément photosensible selon la revendication 3 ou 4, dans lequel l'épaisseur du film de transfert de charges (105) est de 20 micromètres.

6. Elément photosensible selon l'une quelconque des revendications précédentes, dans lequel la résistivité du film de passivation (106) est d'environ 10¹¹ à 10⁹ ohm cm.

7. Elément photosensible selon l'une quelconque des revendications précédentes, dans lequel la transparence du film de passivation (106) n'est pas inférieure à 80 % pour des rayons lumineux ayant une longueur d'onde de 500 nm ou plus.

8. Elément photosensible selon l'une quelconque des revendications précédentes, dans lequel la transparence du film de passivation (106) n'est pas inférieure à 60 % pour des rayons lumineux ayant une longueur d'onde de 400 nm ou plus.

9. Elément photosensible selon l'une quelconque des revendications précédentes, dans lequel la couche photosensible est une couche photosensible organique.

10. Elément photosensible selon l'une quelconque des revendications 1 à 8, dans lequel la couche photosensible est une couche photosensible de silicium amorphe ou de sélénium.

11. Procédé de formation d'un élément photosensible selon l'une quelconque des revendications précédentes, comprenant une structure comportant une couche photosensible, caractérisé par les étapes consistant à former un film de passivation sur la couche photosensible par CVD, étant précisé qu'en plus d'un gaz de composé carboné, un gaz contenant un halogène est introduit dans une chambre de réaction, le film de passivation comprenant une première et une deuxième couches carbonées contenant des atomes d'halogène, la première couche étant formée par dépôt direct sur ladite couche photosensible et la deuxième couche carbonée étant formée par dépôt sur la première couche carbonée, le débit de gaz contenant un halogène pour produire la première couche étant inférieur à celui utilisé pour produire la deuxième couche et le temps de dépôt pour la première couche étant sensiblement inférieur à celui pour la deuxième couche.

12. Utilisation d'un élément photosensible selon l'une quelconque des revendications 1 à 10 en électrophotographie pour former une image en fonction de l'existence ou de l'absence de rayons lumineux incidents sur l'élément.

13. Utilisation selon la revendication 12, comprenant les étapes consistant à charger l'élément, à amener certaines régions de l'élément à recevoir des rayons lumineux et d'autres pas, à appliquer du toner à l'élément et à transférer le toner à la surface d'une feuille pour y former une image.

14. Appareil formateur d'images comprenant des moyens pour charger un élément photosensible selon l'une quelconque des revendications 1 à 10, pour amener certaines régions de l'élément à recevoir des rayons lumineux et d'autres pas, pour appliquer du toner à l'élément et pour transférer le toner à la surface d'une feuille pour y former une image.
